(19) Europäisches Patentamt / European Patent Office / Office européen des brevets

(11) **EP 3 654 047 B1**

(12) **FASCICULE DE BREVET EUROPEEN**

(45) Date de publication et mention de la délivrance du brevet:
**26.05.2021 Bulletin 2021/21**

(51) Int Cl.:
***G01R 31/367*** *(2019.01)*

(21) Numéro de dépôt: **19207800.4**

(22) Date de dépôt: **07.11.2019**

(54) **PROCÉDÉ DE DIAGNOSTIC D'UNE PILE À COMBUSTIBLE**

DIAGNOSEVERFAHREN EINER BRENNSTOFFZELLE

DIAGNOSTIC METHOD FOR A FUEL CELL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.11.2018 FR 1860490**

(43) Date de publication de la demande:
**20.05.2020 Bulletin 2020/21**

(73) Titulaires:
• **Commissariat à l'Énergie Atomique et aux Énergies Alternatives 75015 Paris (FR)**
• **Université Grenoble Alpes 38400 Saint-Martin-d'Hères (FR)**
• **Institut Polytechnique de Grenoble 38500 Grenoble (FR)**

(72) Inventeurs:
• **JULLIAN, Gauthier 38054 Grenoble cedex 9 (FR)**
• **BERENGUER, Christophe 38240 MEYLAN (FR)**
• **CADET, Catherine 38700 LA TRONCHE (FR)**
• **GERARD, Mathias 38054 GRENOBLE CEDEX 9 (FR)**
• **HEIRIES, Vincent 38054 GRENOBLE CEDEX 9 (FR)**
• **ROSINI, Sébastien 38054 GRENOBLE CEDEX 9 (FR)**

(74) Mandataire: **INNOV-GROUP 310, avenue Berthelot 69372 Lyon Cedex 08 (FR)**

(56) Documents cités:
WO-A1-2016/071801 FR-A1- 2 888 331
US-A1- 2016 149 240

• JAHNKE T ET AL: "Performance and degradation of Proton Exchange Membrane Fuel Cells: State of the art in modeling from atomistic to system scale", JOURNAL OF POWER SOURCES, ELSEVIER SA, CH, vol. 304, 6 décembre 2015 (2015-12-06), pages 207-233, XP029351359, ISSN: 0378-7753, DOI: 10.1016/J.JPOWSOUR.2015.11.041

EP 3 654 047 B1

**Description**

**Domaine technique de l'invention**

La présente invention se rapporte à un procédé de diagnostic d'une pile à combustible. L'invention concerne également un système de diagnostic d'une pile à combustible.

**Etat de la technique**

Une pile à combustible est un générateur dans lequel la fabrication de l'électricité se fait grâce à l'oxydation sur une électrode d'un combustible réducteur (par exemple dihydrogène), couplée à la réduction sur l'autre électrode d'un oxydant, tel que le dioxygène de l'air. La réaction d'oxydation de l'hydrogène est accélérée par un catalyseur qui est généralement du platine. Si d'autres combinaisons sont possibles, la pile la plus couramment étudiée et utilisée est la pile dihydrogène-dioxygène ou dihydrogène-air (ceci s'expliquant notamment par l'abondance des ressources en hydrogène sur Terre et la facilité de production du dihydrogène).

La pile à combustible la plus couramment utilisée et étudiée est la pile dite PEMFC pour "Polymer Exchange Membrane Fuel Cells", fonctionnant avec de l'hydrogène et caractérisée par une basse température de fonctionnement. Elle transforme l'énergie chimique, libérée par la réaction entre de l'hydrogène et de l'oxygène, en énergie électrique, formant ainsi des molécules d'eau. Pour que cette pile fonctionne, la membrane qui compose l'électrolyte doit conduire les protons hydrogène sans conduire les électrons. Afin d'augmenter les rendements électriques elle doit également limiter les pertes en flux de protons. La membrane est le cœur de la pile à combustible et il est nécessaire de la préserver pour permettre le bon fonctionnement de la pile. Ainsi pour augmenter la conductivité ionique de la membrane, il est nécessaire de contrôler plusieurs paramètres, la température de fonctionnement de la pile, la pression des gaz ainsi que l'hydratation de la membrane.

Actuellement, de nombreuses études sont menées pour essayer de déterminer l'état d'une pile à combustible, notamment les piles de type PEMFC, et de caractériser son vieillissement. C'est le cas par exemple dans la demande de brevet référencée WO2016/071801A1. La solution décrite dans cette demande de brevet se base sur la spectroscopie d'impédance électrochimique et l'identification de paramètres d'un circuit équivalent. Les principales étapes du procédé décrit dans cette demande sont les suivantes :

- L'obtention des paramètres d'un circuit équivalent en fonction des conditions opératoires en l'absence de défaut puis l'obtention de l'impédance de ce circuit équivalent,
- La mesure de l'impédance sur une large bande de fréquence (des hautes aux basses fréquences),
- Quantification de l'écart entre l'impédance réelle et celle du circuit équivalent,
- Dans le cas où l'écart dépasse le seuil, identification d'un circuit équivalent plus complexe identifié sur l'impédance mesuré,
- Résidu entre les éléments du nouveau circuit équivalent et de celui en l'absence de défauts,
- Création d'une matrice de défaut par comparaison pour chaque résidu avec un seuil,
- Détermination du défaut basé sur la matrice de défaut.

Cette méthode n'est cependant pas satisfaisante car elle ne permet pas de tenir compte de la dynamique de fonctionnement lors des conditions opératoires, ni des changements de comportement liés au vieillissement de la pile. De plus, elle se sert de la mesure d'impédance sur toute la bande de fréquence (notamment à basse fréquence, ce qui rend la mesure en temps réel impossible).

Le document FR2888331A1 décrit un procédé qui permet d'évaluer les conditions de fonctionnement d'une pile à combustible et de détecter des dysfonctionnements. Ce procédé s'appuie sur l'emploi d'un modèle électrique de la pile à combustible dans lequel chaque élément de la pile est modélisé par une grandeur électrique (résistance ohmique pour la membrane par exemple, et schéma électrique incluant impédance de Warburg, résistance en série et CPE en parallèle pour la cathode). La variation de ces grandeurs électriques permet de déterminer l'état de fonctionnement de la pile (noyade, assèchement).

Le but de l'invention est de proposer un procédé de diagnostic d'une pile à combustible qui soit fiable, rapide, grâce à des temps de traitement réduits, et tenant compte des conditions particulières de fonctionnement en dynamique de la pile à combustible et de son vieillissement.

Cette méthode sera mise en œuvre à l'aide d'un programme d'ordinateur destiné à être exécuté sur une unité de traitement, en coopération avec des moyens de mesure particuliers appliqués à la pile à combustible. Ce programme d'ordinateur sera préférentiellement stocké sur un support de stockage lisible par l'unité de traitement.

**Exposé de l'invention**

Ce but est atteint par un procédé de diagnostic d'une pile à combustible qui comporte les étapes suivantes :

- Acquisition, avantageusement par mesure, du courant électrique produit par la pile à combustible à un premier instant,
- Acquisition, avantageusement par mesure, de la tension aux bornes de la pile à combustible et de l'impédance de la pile à combustible audit premier instant,
- Estimation dans des conditions normales de fonctionnement, à partir dudit courant mesuré injecté dans un premier modèle simplifié reliant la variation de la tension en fonction du courant et la variation de l'impédance électrique en fonction du courant, d'une tension théorique aux bornes de la pile audit premier instant et de l'impédance électrique théorique de la pile audit premier instant,
- Détermination d'un premier résidu entre ladite tension mesurée et ladite tension théorique déterminée,
- Détermination d'un deuxième résidu entre ladite impédance mesurée et ladite impédance électrique théorique déterminée,
- Comparaison du premier résidu obtenu avec une première valeur seuil et comparaison du deuxième résidu obtenu avec une deuxième valeur seuil,
- Détermination d'au moins un type de défaut à partir d'un deuxième modèle simplifié configuré pour relier les valeurs prises par les deux résidus à un type de défaut,
- Le premier modèle simplifié et ledit deuxième modèle simplifié étant générés chacun à partir d'un modèle physique de la pile à combustible intégrant un module de dégradation de la pile à combustible tenant compte du courant et de la tension appliqués à ladite pile à combustible au cours d'une période antérieure audit premier instant,
- Ledit premier modèle simplifié étant obtenu en appliquant en entrée dudit modèle physique de la pile à combustible, dans des conditions opératoires nominales, plusieurs points de fonctionnement en courant distincts,
- Ledit deuxième modèle simplifié étant obtenu en appliquant en entrée dudit modèle physique de la pile à combustible, dans des conditions de défaut, plusieurs points de fonctionnement en courant distincts.

Selon une particularité, l'impédance électrique mesurée et l'impédance théorique correspondent à la l'impédance haute fréquence.

Selon une autre particularité, le procédé comporte une première étape intermédiaire de comparaison du premier résidu obtenu avec une première valeur seuil et une deuxième étape intermédiaire de comparaison du deuxième résidu obtenu avec une deuxième valeur seuil.

Selon une autre particularité, chaque modèle simplifié employé est mis à jour hors ligne.

Selon une autre particularité, chaque modèle simplifié est mis en ligne à un instant Tj et est calculé préalablement pendant une période allant d'un instant T_cal_j à Tj, chaque modèle simplifié étant généré en se basant sur des données de mesure de tension et de courant de la pile à combustible sur une période allant d'un instant de référence T0 à l'instant T_cal_J, lesdites données acquises étant injectées dans ledit modèle physique de la pile à combustible.

Selon une autre particularité, le deuxième modèle simplifié est généré par un classifieur configuré pour classer les couples de résidu obtenus en fonction du type de défaut et pour générer des frontières délimitant plusieurs zones de défaut.

Selon une autre particularité, le classifieur comporte un algorithme de type k-NN.

Selon une autre particularité, le procédé comporte une étape de génération d'une action corrective tenant compte du type de défaut détecté.

L'invention concerne également un système de diagnostic d'une pile à combustible, comprenant :

- Un module d'acquisition du courant électrique produit par la pile à combustible à un premier instant,
- Un module d'acquisition de la tension aux bornes de la pile à combustible et de l'impédance de la pile à combustible audit premier instant,
- Un module d'estimation dans des conditions normales de fonctionnement, à partir dudit courant mesuré injecté dans un premier modèle simplifié reliant la variation de la tension en fonction du courant et la variation de la l'impédance en fonction du courant, d'une tension théorique aux bornes de la pile audit premier instant et d'une impédance théorique de la pile audit premier instant,
- Un module de détermination d'un premier résidu entre ladite tension mesurée et ladite tension théorique déterminée,
- Un module de détermination d'un deuxième résidu entre ladite impédance mesurée et ladite impédance théorique déterminée,
- Un module de comparaison du premier résidu obtenu avec une première valeur seuil et comparaison du deuxième résidu obtenu avec une deuxième valeur seuil,
- Un module de détermination d'au moins un type de défaut à partir d'un deuxième modèle simplifié (M2_J) configuré pour relier les valeurs prises par les deux résidus à un type de défaut,

- Le premier modèle simplifié et ledit deuxième modèle simplifié étant générés chacun à partir d'un modèle physique de la pile à combustible intégrant un module de dégradation de la pile à combustible tenant compte du courant et de la tension appliqués à ladite pile à combustible au cours d'une période antérieure audit premier instant,
- Ledit premier modèle simplifié étant obtenu en appliquant en entrée dudit modèle physique de la pile à combustible, dans des conditions opératoires nominales, plusieurs points de fonctionnement en courant distincts,
- Ledit deuxième modèle simplifié étant obtenu en appliquant en entrée dudit modèle physique de la pile à combustible, dans des conditions de défaut, plusieurs points de fonctionnement en courant distincts.

Selon une particularité, l'impédance électrique mesurée et l'impédance théorique correspondent à l'impédance haute fréquence.

Selon une autre particularité, le système comporte un premier module de comparaison du premier résidu obtenu avec une première valeur seuil et un deuxième module de comparaison du deuxième résidu obtenu avec une deuxième valeur seuil.

Selon une autre particularité, le système comporte des moyens de mise à jour hors ligne de chaque modèle simplifié employé.

Selon une autre particularité, le système comporte :

- Des moyens de mise en ligne de chaque modèle simplifié à un instant Tj,
- Un module de calcul de chaque module simplifié exécuté pendant une période allant d'un instant T_cal_j à Tj,
- Un module d'acquisition des données de mesure de tension et de courant de la pile à combustible sur une période allant d'un instant de référence T0 à l'instant T_cal_j, lesdites données acquises étant injectées dans ledit modèle physique de la pile à combustible.

Selon une autre particularité, le système comporte un classifieur configuré pour générer le deuxième modèle simplifié, ledit classifieur étant configuré pour classer les couples de résidu obtenus en fonction du type de défaut et pour générer des frontières délimitant plusieurs zones de défaut.

Selon une autre particularité, le classifieur comporte un algorithme de type k-NN.

Selon une autre particularité, le système comporte un module de détermination d'une action corrective tenant compte du type de défaut détecté et un module de commande de ladite action corrective déterminée.

L'invention concerne également un programme d'ordinateur comprenant des modules logiciels destinés à être exécutés sur un ordinateur pour mettre en œuvre le procédé tel que défini ci-dessus.

L'invention concerne également un support de stockage lisible par un ordinateur comportant le programme d'ordinateur défini ci-dessus.

## Brève description des figures

D'autres caractéristiques et avantages vont apparaître dans la description détaillée qui suit, faite en liaison des figures annexées et listées ci-dessous :

- La figure 1 illustre de manière schématique et simplifiée le principe de fonctionnement d'une cellule employée dans un assemblage en stack d'une pile à combustible ;
- La figure 2 représente de manière schématique l'architecture du système de diagnostic de l'invention ;
- La figure 3 représente un diagramme illustrant les étapes du procédé de diagnostic de l'invention ;
- La figure 4 représente un diagramme illustrant de manière graphique un exemple de classification des défauts pouvant apparaître dans une pile à combustible en fonctionnement ;
- La figure 5 représente un diagramme temporel (tps) illustrant le principe de génération de chaque modèle simplifié employé dans la mise en œuvre du procédé de l'invention ;

## Description détaillée d'au moins un mode de réalisation

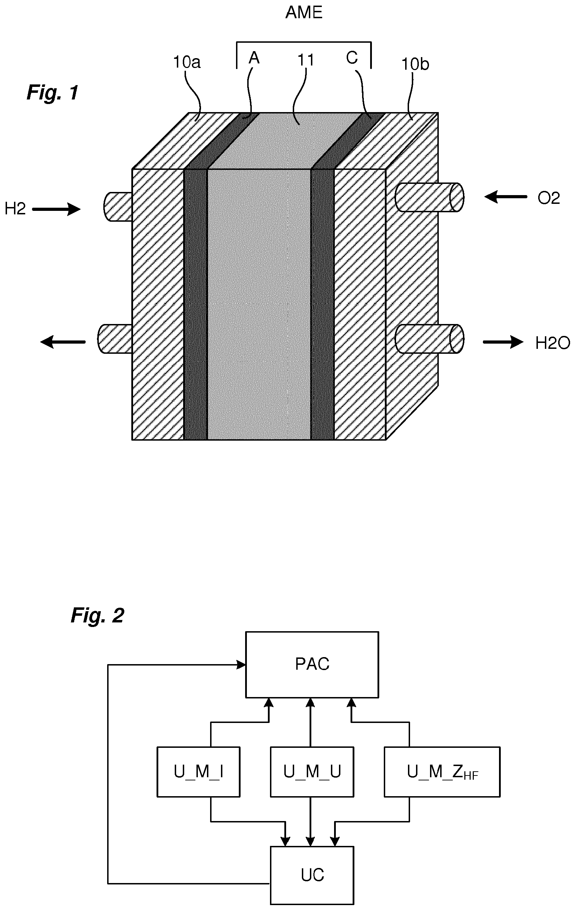

En référence à la figure 1, de manière connue, une cellule employée dans un assemblage en stack d'une pile à combustible comporte classiquement :

- Des plaques bipolaires (non représentées sur la figure 1) : Elles ont pour objectif de permettre l'acheminement des réactifs vers les couches de diffusion (voir ci-dessous). Il est donc nécessaire qu'elles soient imperméables pour éviter toute fuite des gaz vers l'extérieur et vers les compartiments adjacents. Elles doivent également assurer le rôle de collecteur de courant vers le circuit extérieur ou vers la cellule voisine dans le cas d'un "stack" et permettre l'évacuation de la chaleur générée par la réaction. Enfin, c'est également elles qui assurent le maintien mécanique de la cellule. Elles sont, la plupart du temps, fabriquées en graphite, matériaux composites ou en métal (type acier inoxydable, aluminium, titane ou nickel).

- Les couches de diffusion 10a, 10b : Elles sont appelées GDL en anglais pour "Gas Diffusion Layer". Elles ont plusieurs objectifs à remplir : elles doivent être perméables aux gaz et donc poreuses afin d'amener les réactifs depuis les canaux jusqu'aux électrodes, elles assurent également la conduction des électrons et de la chaleur. Elles sont généralement constituées de fibres sous forme de papier ou alors tissées entre elles.

- L'Assemblage Membrane Électrode (AME), ou MEA en anglais pour "Membrane Electrode Assembly" : Cet assemblage comporte une première couche active appelée l'anode A, qui permet la dissociation de la molécule de dihydrogène H2 en électrons et en protons. Les électrons générés partent ensuite vers la couche de diffusion 10a tandis que les protons traversent la membrane 11 pour rejoindre l'oxygène O2 et d'autres électrons venant du circuit extérieur. Ces trois éléments se combinent au niveau de la deuxième couche active, la cathode C, pour former de l'eau H2O. Ainsi, l'AME a pour rôle de catalyser des réactions chimiques au niveau des électrodes et d'être un bon conducteur ionique au niveau de la membrane. Les principaux matériaux utilisés dans la conception des AME sont tout d'abord les polymères perfluorés sulfonés, tel que le Nafion (marque déposée), qui forment la membrane sur une fine épaisseur allant de 10 à 100 $\mu m$ d'épaisseur selon les applications. Les électrodes sont composées principalement de Platine pour le catalyseur de carbone servant comme support pour le catalyseur et d'un polymère facilitant la percolation protonique au sein de l'électrode.

En référence à la figure 2, le système de diagnostic de l'invention est décrit ci-dessous.

L'invention concerne un procédé mis en œuvre pour diagnostiquer une pile à combustible, référencée PAC, et connaître son état de fonctionnement afin de détecter la présence d'éventuels défauts de fonctionnement. Il est réalisé grâce à un programme informatique exécuté par une unité de traitement et mémorisé dans ladite unité de traitement sur un support mémoire lisible. Tous les types de supports, intégrés à la pile à combustible surveillée ou dans une unité de traitement distincte, amovibles ou accessibles à travers un réseau de communication, et classiquement utilisés pour mémoriser un programme informatique, pourront être envisagés.

Le procédé de diagnostic comporte une partie qui est exécutée en ligne, c'est-à-dire en interaction directe avec la pile à combustible PAC pour diagnostiquer son état réel, et une partie qui est exécutée hors ligne et destinée à être en interaction avec la partie en ligne pour permettre le diagnostic de la pile à combustible PAC.

En référence à la figure 2, le système de diagnostic employé pour mettre en œuvre le procédé comporte :

- Une unité de traitement UC comportant des moyens de calculs tels qu'un microprocesseur et des moyens de mémorisation, employés pour exécuter les différentes étapes du procédé de diagnostic conforme à l'invention ; On verra ci-après que l'unité de traitement UC comporte plusieurs modules logiciels exécutés pour la mise en œuvre des différentes étapes du procédé de l'invention ;

- Une unité de mesure du courant électrique U_M_I produit par la pile à combustible ; Il peut s'agir de simples capteurs de courant ;

- Une unité de mesure de la tension électrique U_M_U aux bornes de la pile à combustible ; Il peut s'agir de capteurs de tension ;

- Une unité de mesure de la résistance/impédance électrique U_M_$Z_{HF}$ de la pile à combustible ; L'impédance de la pile à combustible peut être déterminée par spectroscopie d'impédance électrochimique ; Pour obtenir un diagnostic en temps réel, seule l'impédance haute fréquence est mesurée ;

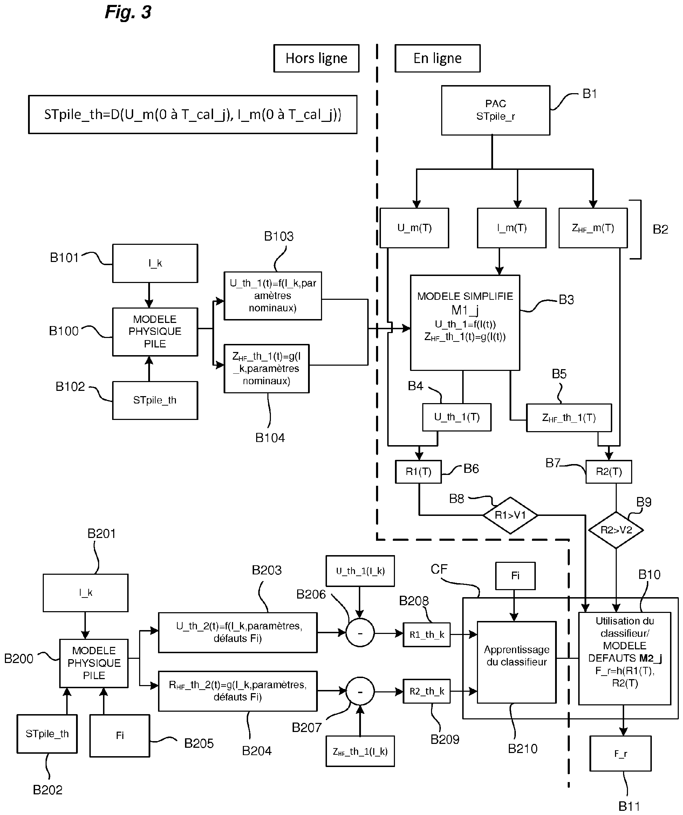

La figure 3 représente un diagramme permettant d'illustrer les différentes étapes et blocs mis en œuvre pour réaliser un diagnostic sur l'état d'une pile à combustible.

Dans la partie en ligne, la pile à combustible PAC est caractérisée par un état réel référencé STpile_r (B1). Le diagnostic sur l'état de la pile est réalisé à un instant T.

Les différentes unités de mesure citées ci-dessus mesurent le courant, la tension et l'impédance haute fréquence, de manière à obtenir une valeur de courant I_m mesuré à l'instant T, une valeur de tension U_m mesurée à l'instant T et une valeur d'impédance haute fréquence $Z_{HF}$_m mesurée à l'instant T (B2). Les mesures effectuées sont ensuite acquises par un module d'acquisition de courant et un module d'acquisition de tension de l'unité de traitement UC.

La valeur de courant I_m mesuré à l'instant T est injectée dans un premier modèle simplifié M1_j de la pile à combustible PAC (B3). Ce premier modèle simplifié M1_j sera explicité ci-dessous.

Ce premier modèle simplifié M1_j permet de déterminer une valeur de tension théorique U_th_1 à l'instant T (B4) et une valeur d'impédance haute fréquence théorique $Z_{HF}$_th_1 à l'instant T (B5).

Un module de calcul détermine une première différence entre la valeur de tension U_m mesurée à l'instant T et la valeur de tension théorique U_th_1 obtenue et une deuxième différence entre la valeur d'impédance haute fréquence $Z_{HF}$_m mesurée à l'instant T et la valeur d'impédance théorique $Z_{HF}$_th_1 à l'instant T. Il en ressort respectivement un premier résidu R1 (B6) et un deuxième résidu R2 (B7), représentant chacun un écart entre la valeur réelle (mesurée) et la valeur théorique calculée pour l'instant T.

Un module de comparaison est chargé de comparer chacun des deux résidus R1, R2 avec une valeur seuil V1, V2 distincte (B8, B9). Le niveau de chaque valeur seuil pourra dépendre du niveau de tolérance qu'il est possible d'octroyer au système. Le seuil de détection est choisi pour éviter les fausses alarmes si le résidu est faible. Le bruit de mesure et l'emploi du modèle simplifié vont en effet nécessairement générer un résidu faible, même si la pile ne présente aucun défaut. Il est bien entendu possible d'ajuster chaque valeur seuil pour maximiser la détection de défaut et minimiser la quantité de fausses alarmes. Cette quatrième étape est optionnelle et permet simplement de détecter la présence ou l'absence de défaut. Sa mise en œuvre permet de ne pas procéder systématiquement à la cinquième étape décrite ci-dessous, liée à la détermination du type de défaut.

Lorsqu'une valeur seuil est dépassée par l'un et/ou l'autre des deux résidus calculés, il s'agit ensuite de déterminer le type de défaut dont la présence a été détectée.

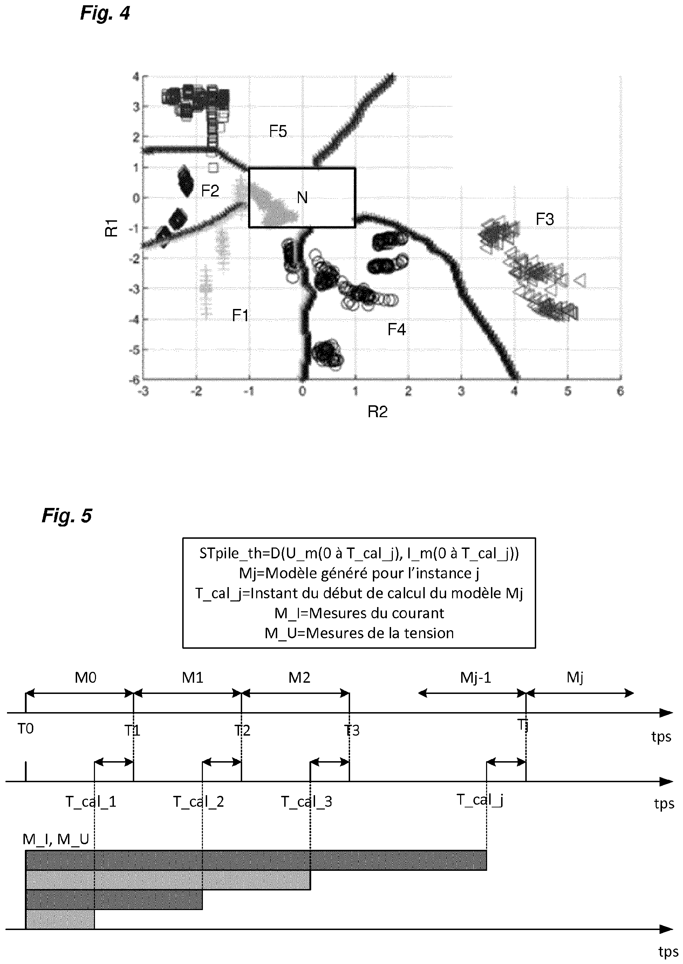

Dans ce cas, les deux résidus R1, R2 obtenus sont injectés dans un deuxième modèle simplifié M2_j (B10) qui classe les différents types de défauts en fonction des couples de valeurs des deux résidus. La valeur obtenue pour le premier résidu R1 à l'instant T et la valeur obtenue pour le deuxième résidu R2 à l'instant T permettent de déduire le type de défaut F_r (B11). La figure 4 représente un graphique illustrant une classification des défauts. De manière non limitative, les défauts sont ainsi classés en cinq types F1 à F5 listés ci-dessous :

| N° du Défaut | Nom du défaut |
|---|---|
| F1 | Faute de température |
| F2 | Noyage |
| F3 | Assèchement |
| F4 | Baisse de la pression partielle |
| F5 | Augmentation de la pression partielle |

Sur la figure 4, sont représentées des limites ou frontières définissant cinq zones, correspondant chacune à un type de défaut F1 à F5. La partie centrale du graphique, référencée N, correspond à une zone sans défaut, c'est-à-dire aux conditions nominales de fonctionnement de la pile. Les frontières sont calculées par le modèle simplifié (ci-après appelé classifieur) à partir de simulations réalisées sur un modèle physique de la pile à combustible dans des conditions de défaut. Sur cette figure 4, le premier résidu R1 est en ordonnées et le deuxième résidu R2 est en abscisses. Selon la zone où se trouve le couple de résidus R1, R2 déterminé, il est ainsi possible d'en déduire directement le type de défaut F_r. On verra ci-après le principe de génération de ce deuxième modèle simplifié M2_j.

Dans la partie hors ligne du procédé schématisé sur la figure 3, il s'agit de générer les deux modèles simplifiés qui sont employés dans la partie en ligne.

Les deux modèles simplifiés M1_j, M2_j sont générés à partir d'un modèle physique B100, B200 de la pile à combustible PAC. Ce modèle physique est par exemple connu sous le nom de MePHYSTO-FC. Il s'agit d'un modèle multi-physique et multi-échelles, décrit dans la publication référencée ci-dessous :

- C. Robin, M. Gerard, J. d'Arbigny, P. Schott, L. Jabbour, Y Bultel, Development and experimental validation of a PEM fuel cell 2D-model to study heterogeneities effects along large-area cell surface, International Journal of Hydrogen Energy, Volume 40, Issue 32,2015, Pages 10211-10230,ISSN 0360-3199, https://doi.org/10.1016/j.ijhydene.2015.05.178.

Ce modèle physique est basé sur des lois physiques de diffusion des gaz, de transfert de matière et de chaleur, et sur des lois électrochimiques de production de l'électricité. Il prend en compte la diffusion des gaz, un flux diphasique liquide-gaz, le transfert de chaleur et la réaction électrochimique. Le modèle calcule les conditions locales et la distribution de courant sur la surface de la cellule en réponse aux conditions opératoires dynamiques. Ce modèle physique contient ainsi des lois qui permettent de modéliser le vieillissement du stack. Il est ainsi possible d'estimer le fonctionnement nominal de la pile à différents niveaux de puissance et pendant toute sa durée de vie.

Ce modèle physique étant couteux en temps de calcul, il est ainsi simplifié de manière à obtenir le premier modèle simplifié M1_j, présentant l'avantage de pouvoir fonctionner en temps réel. De manière non limitative, le premier modèle simplifié M1_j peut simplement être une base de données qui lie, en fonction du courant et de l'état de vieillissement (défini comme la variation de surface active de catalyseur), la tension et l'impédance haute fréquence de la pile à combustible. Il faut noter qu'il existe plusieurs types de réduction de modèle, des méthodes de type construction d'une base donnée, mais aussi des méthodes de réduction de modèle plus formalisée (POD,...).

Le modèle physique de la pile intègre en effet un module de dégradation de la pile, défini sur la figure 3 par un paramètre référencé STpile_th. Ce module de dégradation permet de tenir compte du vieillissement de la pile à combustible généré par sa dynamique de fonctionnement. Pour mieux comprendre son principe, ce module de dégradation peut s'exprimer par la fonction D suivante :

$$STpile\_th=D(Um(0 \text{ à } Tcal\_j), Im(0 \text{ à } Tcal\_j))$$

Dans laquelle :

- U_m correspond à la tension mesurée aux bornes de la pile sur une période de temps antérieure à la génération du modèle simplifié ;

- I_m correspond au courant mesuré sur la pile sur la même période de temps antérieure à la génération du modèle simplifié ;

La figure 5 représente un diagramme temporel permettant d'illustrer la génération de chaque modèle simplifié (référencé Mj) de la pile à combustible.

Sur la figure 5, on a ainsi les particularités suivantes :

- L'instant T0 correspond avantageusement au début de vie de la pile à combustible. Chaque modèle simplifié est ainsi généré directement en considérant un vieillissement nul ou quasi nul.

- Sur la période comprise entre T0 et T1, le modèle simplifié M0 est employé dans le système. Entre T1 et T2, il s'agit du modèle M1. Ainsi entre Tj-1 et Tj, il s'agit du modèle Mj-1.

- Pour générer chaque modèle simplifié à partir du modèle physique de la pile, une période de calcul est forcément nécessaire. Pour chaque modèle simplifié à générer, cette période démarre avant l'exploitation du modèle. Pour chaque modèle simplifié, cette période démarre à un instant désigné T_cal_j. Pour le modèle M1, la période de calcul débute ainsi à l'instant T_cal_1, alors que le modèle M0 est encore en exploitation et va durer jusqu'à l'instant T1 correspondant à la mise en exploitation du modèle M1. De manière générale, pour le nouveau modèle Mj, la période de calcul démarrera ainsi à l'instant T_cal_j pendant l'exploitation du modèle Mj-1 et se terminera à l'instant Tj auquel le modèle Mj sera alors mis en exploitation.

- De manière générale, lorsque le calcul d'un nouveau modèle Mj démarre à l'instant T_cal_J, celui-ci se base sur au moins un échantillon de données de mesure disponibles jusqu'à cet instant T_cal_j. Il s'agit donc des données de mesure de courant M_I et des données de mesure de tension M_U. Ces données sont en effet le reflet des sollicitations de la pile à combustible PAC depuis son début de vie. Pour le modèle Mj, il s'agit donc des données de mesure disponibles entre T0 et T_cal_j.

Selon un aspect particulier de l'invention, chaque modèle simplifié M1_j, M2_j est ainsi mis à jour régulièrement pour tenir compte de la dynamique de fonctionnement de la pile à combustible en cours d'utilisation. Bien entendu, la période de calcul choisie peut ne pas être fixe pour chaque génération de modèle. On peut en effet penser que celle-ci pourrait aller en augmentant au fur et à mesure du vieillissement de la pile à combustible.

Bien entendu, pour des questions de cohérence, les deux modèles simplifiés M1_j, M2_j employés en ligne devront être calculés sur les mêmes données d'entrée, obtenues sur une même période de temps (c'est-à-dire sur la période allant de T0 à T_cal_j).

En reprenant la figure 3, le premier modèle simplifié M1_j est ainsi obtenu en appliquant en entrée du modèle physique de la pile plusieurs points de fonctionnement en courant I_k (B101), en tenant compte du vieillissement de la pile exprimé sur la figure 5 par le paramètre STpile_th (B102). Un point de fonctionnement en courant I_k correspond à une valeur discrète de courant. Il s'agira ainsi de faire varier le courant appliqué en entrée du modèle physique de la pile, pour lui faire prendre plusieurs valeurs prédéfinies successives. De manière non limitative, chaque valeur de courant peut être choisie comprise entre 0 et 1 A/cm$^2$. Pour chaque valeur de courant appliquée en entrée, l'unité de traitement UC mémorise la valeur théorique de tension U_th_1 obtenue (B103) et la valeur théorique de l'impédance haute fréquence $Z_{HF}$_th_1 obtenue (B104), après application du modèle physique de la pile (qui intègre le module de dégradation évoqué ci-dessus).

Selon un aspect particulier de l'invention, le premier modèle simplifié M1_j est généré en tenant compte de paramètres de fonctionnement nominaux de la pile à combustible, c'est-à-dire en considérant que la pile à combustible PAC est sans défaut de fonctionnement. Ces paramètres nominaux sont par exemple les suivants :

Température : T=80° C,

Humidité relative : HR=50%,

Pression : P=1.5 bar,

Stœchiométrie $St_a$ = 1.5, $St_c$ = 2

Bien entendu, ils dépendent du type de pile employé et ces paramètres nominaux ne sont pas à considérer de manière limitative.

Pour ce premier modèle simplifié M1_j, on obtient ainsi, en sortie du modèle physique de la pile, les données pouvant s'exprimer par les deux fonctions suivantes :

U_th_1=f(I_k, paramètres nominaux)

$Z_{HF}$_th_1=g(I_k, paramètres nominaux)

Dans lesquelles :

- U_th_1 représente une valeur théorique de tension obtenue pour chaque point de fonctionnement en courant I_k, dans des conditions nominales de fonctionnement de la pile ;

- $Z_{HF}$_th_1 représente une valeur théorique de l'impédance haute fréquence obtenue pour chaque point de fonctionnement I_k dans des conditions nominales de fonctionnement de la pile ;

- I_k représente chaque point de fonctionnement en courant ;

Le premier modèle simplifié M1_j qui est utilisé en ligne regroupe ainsi toutes les valeurs obtenues pour U_th_1 et $Z_{HF}$_th_1. Celui-ci est mis à jour régulièrement de la manière décrite ci-dessus en liaison avec la figure 5, pour tenir compte du vieillissement de la pile à combustible PAC.

Le deuxième modèle simplifié M2_j est pour sa part généré en modifiant les conditions nominales de manière à simuler des défauts de fonctionnement de la pile à combustible PAC. Pour simuler chaque défaut Fi (défauts F1 à F5 (B205)) déjà défini ci-dessus, les paramètres correspondants au défaut à simuler sont modifiés pour s'écarter des conditions nominales. Pour chaque défaut F1 à F5, on agit ainsi de la manière décrite dans le tableau ci-dessous :

| N° du Défaut | Nom du défaut | Conditions modifiées |
|---|---|---|
| F1 | Faute de température | T=75°C à 60°C |
| F2 | Noyage | RH=55% à 80% |
| F3 | Assèchement | RH=45% à 20% |
| F4 | Baisse de la pression partielle | P=1.2 bar et $St_a$ 1.5 à 1.2, $St_c$ 2 à 1.5 |
| F5 | Augmentation de la pression partielle | P=2.5 bar et $St_a$ 1.5 à 2, $St_c$ 2 à 2.5 |

Par ailleurs, comme pour le modèle simplifié précédent, on applique en entrée du modèle physique de la pile plusieurs points de fonctionnement en courant I_k (B201), en tenant compte du vieillissement de la pile exprimée sur la figure 4 par le paramètre STpile_th (B202)

Pour ce deuxième modèle simplifié M2_j, on obtient ainsi en sortie du modèle physique (B200) les données pouvant s'exprimer par les deux fonctions suivantes (B203, B204) :

U_th_2=f(I_k, paramètres défauts)

$Z_{HF}$_th_2=g(I_k, paramètres défauts)

Dans lesquelles :

- U_th_2 représente une valeur théorique de tension obtenue pour chaque point de fonctionnement en courant I_k, en appliquant des paramètres de défaut de fonctionnement de la pile ;

- $Z_{HF}$_th_2 représente une valeur théorique de l'impédance haute fréquence obtenue pour chaque point de fonctionnement I_k en appliquant des paramètres de défaut de fonctionnement de la pile ;

- I_k représente chaque point de fonctionnement en courant ;

Les valeurs théoriques de tension U_th_2 et de l'impédance haute fréquence $Z_{HF}$_th_2 qui sont obtenues en sortie du modèle physique (B200) pour chaque point de fonctionnement en courant I_k, en appliquant des paramètres de défaut, sont comparées (B206, B207) respectivement avec les valeurs théoriques de tension U_th_1 et de l'impédance haute fréquence $Z_{HF}$_th_1 obtenues pour le même point de fonctionnement en courant I_k, en appliquant les paramètres de fonctionnement nominaux.

Pour chaque point de fonctionnement en courant I_k, on obtient ainsi :

- Un premier résidu R1_th_k (B208) correspondant à la différence entre la valeur théorique de tension U_th_2 dans les conditions de défaut et la valeur théorique de tension U_th_1 dans les conditions normales de fonctionnement ;

- Un deuxième résidu R2_th_k (B209) correspondant à la différence entre la valeur théorique de l'impédance haute fréquence $Z_{HF}$_th_2 dans les conditions de défaut et la valeur théorique de l'impédance haute fréquence $Z_{HF}$_th1 dans les conditions normales de fonctionnement ;

Pour chaque point de fonctionnement I_k, le couple de résidus R1_th_k, R2_th_k obtenu est injecté dans un classifieur CF, destiné à générer le deuxième modèle simplifié M2_j. Ce classifieur CF est un outil mathématique permettant de classer les défauts en fonction de la valeur prise par chaque résidu R1_th_k, R2_th_k dans chaque couple de résidus. Autrement dit, ce classifieur classe les couples de résidus obtenus en fonction du défaut qui a été simulé (B210). Comme illustré par la figure 4, le classifieur CF est par ailleurs capable de définir les frontières entre les différentes zones de défauts afin de pouvoir extrapoler les résultats de simulation obtenus à tout le domaine de fonctionnement. Cette étape d'apprentissage est mise en œuvre hors ligne pendant la période de calcul du modèle simplifié. Une fois le classifieur généré, celui-ci est mis en ligne à l'instant Tj comme précisé ci-dessus, en même temps que le premier modèle simplifié. Il correspond alors au deuxième modèle simplifié M2_j généré. A partir des deux résidus calculés R1 (T) et R2(T) calculés en ligne pour l'instant T, le modèle M2_j (B10) permet de remonter au type de défaut F_r (B11) présent dans la pile à combustible. Pour cela, il suffit d'identifier la zone dans laquelle le couple de résidu est situé pour en déduire le type de défaut rencontré par la pile à combustible à l'instant T.

En fonction du type de défaut identifié, une action corrective peut être menée pour rétablir des conditions de fonctionnement nominales. L'unité de traitement exécute un module de détermination de l'action corrective à mener en fonction du type de défaut détecté puis un module de commande destiné à commander un ou plusieurs actionneurs choisis pour la mise en place de l'action corrective.

Le tableau ci-dessous montre une matrice de confusion, caractéristique de la capacité du système de diagnostic de l'invention à correctement identifier les défauts de fonctionnement simulés. Un score global de 91% (calculé comme étant le ratio entre le nombre de défauts correctement identifié sur le nombre de mesures réalisées) est obtenu, ce qui montre que le système est capable de correctement identifier les défauts de fonctionnement. Il existe cependant quelques défauts qui peuvent s'avérer moins bien identifiés que d'autres. C'est par exemple le cas du défaut température basse (F1) qui peut être confondu avec un noyage dans certains cas (F2). Cette confusion provient du fait qu'une diminution de la température provoque une condensation de l'eau produite par la pile à combustible et donc un noyage partiel des électrodes. Une des solutions pour évacuer l'eau produite par la pile étant d'augmenter la température de travail. Cependant, la confusion entre les deux défauts n'est pas rédhibitoire pour le système, car cela conduit à la même action corrective, c'est-à-dire à augmenter la température.

| Réel \ Estimé | F1 | F2 | F3 | F4 | F5 |
|---|---|---|---|---|---|
| F1 | **68** | **32** | **0** | **0** | **0** |
| F2 | 0,7 | **99,3** | 0 | 0 | 0 |
| F3 | 0 | 0 | **100** | 0 | 0 |

**9**

(suite)

| Réel \ Estimé | F1 | F2 | F3 | F4 | F5 |
|---|---|---|---|---|---|
| F4 | 17 | 0 | 0 | **83** | 0 |
| F5 | 0 | 0,7 | 0 | 0 | **99,3** |

Selon un aspect particulier de l'invention, un classifieur de type k-NN ("k-Nearest Neighbors" ou méthode des plus proches voisins) a été utilisé mais tous les autres algorithmes de classification peuvent fonctionner (machine à vecteurs de support SVM, réseau de neurone NN, ...). Dans le cas d'un algorithme de type k-NN, il s'agit de calculer les distances avec toute la base d'apprentissage ce qui nécessite un temps de calcul important. Un algorithme de type SVM permet pour sa part de n'embarquer que les frontières définissant les fautes, et un réseau de neurone permet de n'embarquer que la structure du réseau avec les poids associés à chaque neurone.

Le procédé et le système de l'invention présentent de nombreux avantages, parmi lesquels :

- Une solution permettant de détecter les défauts de manière fiable ;

- Une solution permettant un diagnostic quasi en temps réel grâce à des temps de calcul suffisamment courts ;

- Une solution ne nécessitant l'emploi que de très peu de capteurs (courant, tension principalement), ces capteurs étant la plupart du temps déjà présents ;


## Revendications

1. Procédé de diagnostic d'une pile à combustible (PAC) comprenant les étapes suivantes :

   - Acquisition du courant électrique (I_m) produit par la pile à combustible à un premier instant (T),
   - Acquisition de la tension (U_m) aux bornes de la pile à combustible et de l'impédance ($Z_{HF}$_m) de la pile à combustible audit premier instant,
   - Estimation dans des conditions normales de fonctionnement, à partir dudit courant mesuré injecté dans un premier modèle simplifié (M1_j) reliant la variation de la tension en fonction du courant et la variation de l'impédance électrique en fonction du courant, d'une tension théorique (U_th_1) aux bornes de la pile audit premier instant et de l'impédance électrique théorique ($Z_{HF}$_th_1) de la pile audit premier instant,
   - Détermination d'un premier résidu (R1) entre ladite tension mesurée (U_m) et ladite tension théorique (U_th_1) déterminée,
   - Détermination d'un deuxième résidu (R2) entre ladite impédance mesuré ($Z_{HF}$_m) et ladite impédance électrique théorique ($Z_{HF}$_th_1) déterminée,
   - Détermination d'au moins un type de défaut à partir d'un deuxième modèle simplifié (M2_J) configuré pour relier les valeurs prises par les deux résidus à un type de défaut,
   - **Caractérisé en ce que** :

   - Le premier modèle simplifié (M1_j) et ledit deuxième modèle simplifié (M2_j) sont générés chacun à partir d'un modèle physique de la pile à combustible intégrant un module de dégradation de la pile à combustible tenant compte du courant et de la tension appliqués à ladite pile à combustible au cours d'une période antérieure audit premier instant,
   - Ledit premier modèle simplifié (M1_j) est obtenu en appliquant en entrée dudit modèle physique de la pile à combustible, dans des conditions opératoires nominales, plusieurs points de fonctionnement en courant (I_k) distincts,
   - Ledit deuxième modèle simplifié (M2_j) est obtenu en appliquant en entrée dudit modèle physique de la pile à combustible, dans des conditions de défaut, plusieurs points de fonctionnement en courant (I_k) distincts.

2. Procédé selon la revendication 1, **caractérisé en ce que** l'impédance électrique mesurée et l'impédance théorique correspondent à la l'impédance haute fréquence.

3. Procédé selon la revendication 1 ou 2, **caractérisé en ce qu'**il comporte une première étape intermédiaire de comparaison du premier résidu obtenu avec une première valeur seuil (V1) et une deuxième étape intermédiaire de comparaison du deuxième résidu obtenu avec une deuxième valeur seuil (V2).

4. Procédé selon l'une des revendications 1 à 3, **caractérisé en ce que** chaque modèle simplifié employé est mis à jour hors ligne.

5. Procédé selon l'une de revendications 1 à 4, **caractérisé en ce que** chaque modèle simplifié (M1_j, M2_j) est mis en ligne à un instant Tj et **en ce qu'**il est calculé préalablement pendant une période allant d'un instant T_cal_j à Tj, chaque modèle simplifié étant généré en se basant sur des données de mesure de tension et de courant de la pile à combustible sur une période allant d'un instant de référence T0 à l'instant T_cal_J, lesdites données acquises étant injectées dans ledit modèle physique de la pile à combustible.

6. Procédé selon l'une des revendications 1 à 5, **caractérisé en ce que** le deuxième modèle simplifié est généré par un classifieur (CF) configuré pour classer les couples de résidu obtenus en fonction du type de défaut et pour générer des frontières délimitant plusieurs zones de défaut.

7. Procédé selon la revendication 6, **caractérisé en ce que** le classifieur comporte un algorithme de type k-NN.

8. Procédé selon l'une des revendications 1 à 7, **caractérisé en ce qu'**il comporte une étape de génération d'une action corrective tenant compte du type de défaut détecté.

9. Procédé selon l'une des revendications 1 à 8, **caractérisé en ce que** l'étape d'acquisition du courant électrique et l'étape d'acquisition de la tension sont mises en œuvre par mesure.

10. Système de diagnostic d'une pile à combustible (PAC), comprenant :

- Un module d'acquisition du courant électrique produit par la pile à combustible à un premier instant (T),
- Un module d'acquisition de la tension aux bornes de la pile à combustible et de l'impédance ($Z_{HF}\_m$) de la pile à combustible audit premier instant,
- Un module d'estimation dans des conditions normales de fonctionnement, à partir dudit courant mesuré injecté dans un premier modèle simplifié (M1_j) reliant la variation de la tension en fonction du courant et la variation de l'impédance en fonction du courant, d'une tension théorique (U_th_1) aux bornes de la pile audit premier instant et d'une impédance théorique (ZHF_th_1) de la pile audit premier instant,
- Un module de détermination d'un premier résidu (R1) entre ladite tension mesurée (U_m) et ladite tension théorique (U_th_1) déterminée,
- Un module de détermination d'un deuxième résidu (R2) entre ladite impédance mesurée ($Z_{HF}\_m$) et ladite impédance théorique ($Z_{HF}\_th\_1$) déterminée,
- Un module de détermination d'au moins un type de défaut à partir d'un deuxième modèle simplifié (M2_J) configuré pour relier les valeurs prises par les deux résidus à un type de défaut,
- **Caractérisé en ce que** :

- Le premier modèle simplifié (M1_j) et ledit deuxième modèle simplifié (M2j) sont générés chacun à partir d'un modèle physique de la pile à combustible intégrant un module de dégradation de la pile à combustible tenant compte du courant et de la tension appliqués à ladite pile à combustible au cours d'une période antérieure audit premier instant,
- Ledit premier modèle simplifié (M1_j) est obtenu en appliquant en entrée dudit modèle physique de la pile à combustible, dans des conditions opératoires nominales, plusieurs points de fonctionnement en courant (I_k) distincts,
- Ledit deuxième modèle simplifié (M2_J) est obtenu en appliquant en entrée dudit modèle physique de la pile à combustible, dans des conditions de défaut, plusieurs points de fonctionnement en courant (I_k) distincts.

11. Système selon la revendication 10, **caractérisé en ce que** l'impédance électrique mesurée et l'impédance théorique correspondent à l'impédance haute fréquence.

12. Système selon la revendication 10 ou 11, **caractérisé en ce qu'**il comporte un premier module de comparaison du premier résidu obtenu avec une première valeur seuil (V1) et un deuxième module de comparaison du deuxième résidu obtenu avec une deuxième valeur seuil (V2).

**13.** Système selon l'une des revendications 10 à 12, **caractérisé en ce qu'**il comporte des moyens de mise à jour hors ligne de chaque modèle simplifié employé.

**14.** Système selon l'une de revendications 10 à 13, **caractérisé en ce qu'**il comporte :

- Des moyens de mise en ligne de chaque modèle simplifié (M1_j, M2_j) à un instant Tj,
- Un module de calcul de chaque module simplifié exécuté pendant une période allant d'un instant T_cal_j à Tj,
- Un module d'acquisition des données de mesure de tension et de courant de la pile à combustible sur une période allant d'un instant de référence T0 à l'instant T_cal_j, lesdites données acquises étant injectées dans ledit modèle physique de la pile à combustible.

**15.** Système selon l'une des revendications 10 à 14, **caractérisé en ce qu'**il comporte un classifieur (CF) configuré pour générer le deuxième modèle simplifié, ledit classifieur (CF) étant configuré pour classer les couples de résidu obtenus en fonction du type de défaut et pour générer des frontières délimitant plusieurs zones de défaut.

**16.** Système selon la revendication 15, **caractérisé en ce que** le classifieur comporte un algorithme de type k-NN.

**17.** Système selon l'une des revendications 10 à 16, **caractérisé en ce qu'**il comporte un module de détermination d'une action corrective tenant compte du type de défaut détecté et un module de commande de ladite action corrective déterminée.

**18.** Programme d'ordinateur comprenant des modules logiciels qui conduisent le système selon les revendications 10-17 à exécuter les étapes de la méthode selon les revendications 1-9.

**19.** Support de stockage lisible par un ordinateur comportant le programme d'ordinateur défini dans la revendication 18.

**Patentansprüche**

**1.** Verfahren zur Diagnose einer Brennstoffzelle (PAC) umfassend die folgenden Schritte:

- Erfassen des elektrischen Stroms (I_m), der von der Brennstoffzelle erzeugt wird, zu einem ersten Zeitpunkt (T),
- Erfassen der Spannung (U_m) an den Anschlüssen der Brennstoffzelle und der Impedanz ($Z_{HF}$_m) der Brennstoffzelle zum ersten Zeitpunkt,
- Schätzen, unter normalen Betriebsbedingungen anhand des gemessenen Stroms, der in ein erstes vereinfachtes Modell (M1_j) injiziert ist, das die Änderung der Spannung in Abhängigkeit vom Strom und die Änderung der elektrischen Impedanz in Abhängigkeit vom Strom in Verbindung bringt, einer theoretischen Spannung (U_th_1) an den Anschlüssen der Zelle zum ersten Zeitpunkt und der theoretischen elektrischen Impedanz ($Z_{HF}$_th_1) der Zelle zum ersten Zeitpunkt,
- Bestimmen eines ersten Rests (R1) zwischen der gemessenen Spannung (U_m) und der bestimmten theoretischen Spannung (U_th_1),
- Bestimmen eines zweiten Rests (R2) zwischen der gemessenen Impedanz ($Z_{HF}$_m) und der bestimmten theoretischen elektrischen Impedanz ($Z_{HF}$_th_1),
- Bestimmen mindestens einer Fehlerart anhand eines zweiten vereinfachten Modells (M2_j), das dazu ausgebildet ist, die Werte, die von den zwei Resten angenommen werden, mit einer Fehlerart in Verbindung zu bringen,
- **Dadurch gekennzeichnet, dass**:

  - Das erste vereinfachte Modell (M1_j) und das zweite vereinfachte Modell (M2_j) jeweils anhand eines physikalischen Modells der Brennstoffzelle erzeugt werden, das ein Modul einer Verschlechterung der Brennstoffzelle enthält, das den Strom und die Spannung berücksichtigt, die im Verlauf einer Zeitspanne vor dem ersten Zeitpunkt an die Brennstoffzelle angelegt sind,
  - Das erste vereinfachte Modell (M1_j) durch Anwendung, am Eingang des physikalischen Modells der Brennstoffzelle unter Nenn-Verfahrensbedingungen, mehrerer gesonderter Strombetriebspunkte (I_k) erhalten wird,
  - Das zweite vereinfachte Modell (M2_J) durch Anwendung, am Eingang des physikalischen Modells der Brennstoffzelle unter Fehlerbedingungen, mehrerer gesonderter Strombetriebspunkte (I_k) erhalten wird.

**2.** Verfahren nach Anspruch 1, **dadurch gekennzeichnet, dass** die gemessene elektrische Impedanz und die theoretische Impedanz der Hochfrequenzimpedanz entsprechen.

3. Verfahren nach Anspruch 1 oder 2, **dadurch gekennzeichnet, dass** es einen ersten Zwischenschritt des Vergleichens des ersten erhaltenen Rests mit einem ersten Schwellenwert (V1) und einen zweiten Zwischenschritt des Vergleichens des zweiten erhaltenen Rests mit einem zweiten Schwellenwert (V2) aufweist.

4. Verfahren nach einem der Ansprüche 1 bis 3, **dadurch gekennzeichnet, dass** jedes verwendete vereinfachte Modell offline aktualisiert wird.

5. Verfahren nach einem der Ansprüche 1 bis 4, **dadurch gekennzeichnet, dass** jedes vereinfachte Modell (M1_j, M2_j) zu einem Zeitpunkt Tj online gestellt wird, und dadurch, dass es zuvor während einer Zeitspanne von einem Zeitpunkt T_cal_j bis Tj berechnet wird, wobei jedes vereinfachte Modell auf Grundlage von Spannungs- und Strommessdaten der Brennstoffzelle über eine Zeitspanne von einem Referenzzeitpunkt T0 bis zum Zeitpunkt T_cal_j erzeugt wird, wobei die erfassten Daten in das physikalische Modell der Brennstoffzelle injiziert sind.

6. Verfahren nach einem der Ansprüche 1 bis 5, **dadurch gekennzeichnet, dass** das zweite vereinfachte Modell von einem Klassifizierer (CF) erzeugt wird, der dazu ausgebildet ist, die erhaltenen Restpaare nach der Fehlerart zu klassifizieren und Grenzen zu erzeugen, die mehrere Fehlerbereiche begrenzen.

7. Verfahren nach Anspruch 6, **dadurch gekennzeichnet, dass** der Klassifizierer einen k-NN-Algorithmus aufweist.

8. Verfahren nach einem der Ansprüche 1 bis 7, **dadurch gekennzeichnet, dass** es einen Schritt des Erzeugens einer Korrekturmaßnahme aufweist, bei der die festgestellte Fehlerart berücksichtigt wird.

9. Verfahren nach einem der Ansprüche 1 bis 8, **dadurch gekennzeichnet, dass** der Schritt des Erfassens des elektrischen Stroms und der Schritt des Erfassens der Spannung durch Messen durchgeführt werden.

10. System zur Diagnose einer Brennstoffzelle (PAC), umfassend:

   - Ein Modul zum Erfassen des elektrischen Stroms, der von der Brennstoffzelle erzeugt wird, zu einem ersten Zeitpunkt (T),
   - Ein Modul zum Erfassen der Spannung an den Anschlüssen der Brennstoffzelle und der Impedanz ($Z_{HF}\_m$) der Brennstoffzelle zum ersten Zeitpunkt,
   - Ein Modul zum Schätzen, unter normalen Betriebsbedingungen anhand des gemessenen Stroms, der in ein erstes vereinfachtes Modell (M1_j) injiziert ist, das die Änderung der Spannung in Abhängigkeit vom Strom und die Änderung der Impedanz in Abhängigkeit vom Strom in Verbindung bringt, einer theoretischen Spannung (U_th_1) an den Anschlüssen der Zelle zum ersten Zeitpunkt und einer theoretischen Impedanz ($Z_{HF}\_th\_1$) der Zelle zum ersten Zeitpunkt,
   - Ein Modul zum Bestimmen eines ersten Rests (R1) zwischen der gemessenen Spannung (U_m) und der bestimmten theoretischen Spannung (U_th_1),
   - Ein Modul zum Bestimmen eines zweiten Rests (R2) zwischen der gemessenen Impedanz ($Z_{HF}\_m$) und der bestimmten theoretischen Impedanz ($Z_{HF}\_th\_1$),
   - Ein Modul zum Bestimmen mindestens einer Fehlerart anhand eines zweiten vereinfachten Modells (M2_j), das dazu ausgebildet ist, die Werte, die von den zwei Resten angenommen werden, mit einer Fehlerart in Verbindung zu bringen,
   - **Dadurch gekennzeichnet, dass**:

      - Das erste vereinfachte Modell (M1_j) und das zweite vereinfachte Modell (M2j) jeweils anhand eines physikalischen Modells der Brennstoffzelle erzeugt werden, das ein Modul einer Verschlechterung der Brennstoffzelle enthält, das den Strom und die Spannung berücksichtigt, die im Verlauf einer Zeitspanne vor dem ersten Zeitpunkt an die Brennstoffzelle angelegt sind,
      - Das erste vereinfachte Modell (M1_j) durch Anwendung, am Eingang des physikalischen Modells der Brennstoffzelle unter Nenn-Verfahrensbedingungen, mehrerer gesonderter Strombetriebspunkte (I_k) erhalten wird,
      - Das zweite vereinfachte Modell (M2_J) durch Anwendung, am Eingang des physikalischen Modells der Brennstoffzelle unter Fehlerbedingungen, mehrerer gesonderter Strombetriebspunkte (I_k) erhalten wird.

11. System nach Anspruch 10, **dadurch gekennzeichnet, dass** die gemessene elektrische Impedanz und die theoretische Impedanz der Hochfrequenzimpedanz entsprechen.

**12.** System nach Anspruch 10 oder 11, **dadurch gekennzeichnet, dass** es ein erstes Modul zum Vergleichen des ersten erhaltenen Rests mit einem ersten Schwellenwert (V1) und ein zweites Modul zum Vergleichen des zweiten erhaltenen Rests mit einem zweiten Schwellenwert (V2) aufweist.

**13.** System nach einem der Ansprüche 10 bis 12, **dadurch gekennzeichnet, dass** es Mittel zur Offline-Aktualisierung jedes verwendeten vereinfachten Modells aufweist.

**14.** System nach einem der Ansprüche 10 bis 13, **dadurch gekennzeichnet, dass** es Folgendes aufweist:

- Mittel zum Onlinestellen jedes vereinfachten Modells (M1_j, M2_j) zu einem Zeitpunkt Tj,
- Ein Mittel zum Berechnen jedes vereinfachten Modells, das während einer Zeitspanne von einem Zeitpunkt T_cal_j bis Tj ausgeführt wird,
- Ein Modul zum Erfassen der Spannungs- und Strommessdaten der Brennstoffzelle über eine Zeitspanne von einem Referenzzeitpunkt T0 bis zum Zeitpunkt T_cal_j, wobei die erfassten Daten in das physikalische Modell der Brennstoffzelle injiziert sind.

**15.** System nach einem der Ansprüche 10 bis 14, **dadurch gekennzeichnet, dass** es einen Klassifizierer (CF) aufweist, der dazu ausgebildet ist, das zweite vereinfachte Modell zu erzeugen, wobei der Klassifizierer (CF) dazu ausgebildet ist, die erhaltenen Restpaare nach der Fehlerart zu klassifizieren und Grenzen zu erzeugen, die mehrere Fehlerbereiche begrenzen.

**16.** System nach Anspruch 15, **dadurch gekennzeichnet, dass** der Klassifizierer einen k-NN-Algorithmus aufweist.

**17.** System nach einem der Ansprüche 10 bis 16, **dadurch gekennzeichnet, dass** es ein Modul zum Bestimmen einer Korrekturmaßnahme, bei der die festgestellte Fehlerart berücksichtigt wird, und ein Modul zum Steuern der bestimmten Korrekturmaßnahme aufweist.

**18.** Computerprogramm umfassend Softwaremodule, die das System nach einem der Ansprüche 10 bis 17 dazu veranlassen, die Schritte des Verfahrens nach den Ansprüchen 1 bis 9 auszuführen.

**19.** Computerlesbares Speichermedium, das das Computerprogramm aufweist, das in Anspruch 18 definiert ist.

## Claims

**1.** Method for diagnosing a fuel-cell stack (PAC) comprising the following steps:

- acquiring the electric current (I_m) produced by the fuel-cell stack at a first time (T),
- acquiring the voltage (U_m) across the terminals of the fuel-cell stack and the impedance ($Z_{HF}$_m) of the fuel-cell stack at said first time,
- estimating, under normal operating conditions, from said measured current injected into a simplified first model (M1_j) relating the variation in the voltage as a function of the current and the variation in the electrical impedance as a function of the current, a theoretical voltage (U_th_1) across the terminals of the stack at said first time and the theoretical electrical impedance ($Z_{HF}$_th_1) of the stack at said first time,
- determining a first residue (R1) between said measured voltage (U_m) and said determined theoretical voltage (U_th_1),
- determining a second residue (R2) between said measured impedance ($Z_{HF}$_m) and said determined theoretical electrical impedance ($Z_{HF}$_th_1),
- determining at least one type of fault using a second simplified model (M2_J) configured to relate the values of the two residues to a type of fault,
- **characterized in that**:

- the first simplified model (M1_j) and said second simplified model (M2_J) are each generated from a physical model of the fuel-cell stack incorporating a fuel-cell stack degradation module that takes into account the current and the voltage that are applied to said fuel-cell stack in a period prior to said first time,
- said first simplified model (M1_j) is obtained by applying, as input to said physical model of the fuel-cell stack, under nominal operating conditions, a plurality of different current operating points (I_k),
- said second simplified model (M2_J) is obtained by applying, as input to said physical model of the fuel-cell stack, under fault-affected operating conditions, a plurality of different current operating points (I_k).

2. Method according to Claim 1, **characterized in that** the measured electrical impedance and the theoretical impedance correspond to the high-frequency impedance.

3. Method according to Claim 1 or 2, **characterized in that** it comprises a first intermediate step of comparing the obtained first residue with a first threshold value (V1) and a second intermediate step of comparing the obtained second residue with a second threshold value (V2).

4. Method according to one of Claims 1 to 3, **characterized in that** each employed simplified model is updated off-line.

5. Method according to one of Claims 1 to 4, **characterized in that** each simplified model (M1_j, M2_j) is updated online at a time Tj and **in that** it is computed beforehand during a period extending from a time T_cal_j to Tj, each simplified model being generated on the basis of data of measurements of voltage and current of the fuel-cell stack over a period extending from a reference time T0 to the time T_cal_j, said acquired data being injected into said physical model of the fuel-cell stack.

6. Method according to one of Claims 1 to 5, **characterized in that** the second simplified model is generated by a classifier (CS) configured to classify the obtained residue pairs depending on the type of fault and to generate boundaries delineating a plurality of fault regions.

7. Method according to Claim 6, **characterized in that** the classifier comprises a k-NN algorithm.

8. Method according to one of Claims 1 to 7, **characterized in that** it comprises a step of generating a corrective action taking into account the type of fault detected.

9. Method according to one of Claims 1 to 8, **characterized in that** the step of acquiring the electric current and the step of acquiring the voltage are implemented by a measurement.

10. System for diagnosing a fuel-cell stack (PAC), comprising:

- a module for acquiring the electric current produced by the fuel-cell stack at a first time (T),
- a module for acquiring the voltage across the terminals of the fuel-cell stack and the impedance ($Z_{HF}\_m$) of the fuel-cell stack at said first time,
- a module for estimating, under normal operating conditions, from said measured current injected into a simplified first model (M1_j) relating the variation in the voltage as a function of the current and the variation in the impedance as a function of the current, a theoretical voltage (U_th_1) across the terminals of the stack at said first time and a theoretical impedance ($Z_{HF}\_th\_1$) of the stack at said first time,
- a module for determining a first residue (R1) between said measured voltage (U_m) and said determined theoretical voltage (U_th_1),
- a module for determining a second residue (R2) between said measured impedance ($Z_{HF}\_m$) and said determined theoretical impedance ($Z_{HF}\_th\_1$),
- a module for determining at least one type of fault using a second simplified model (M2_j) configured to relate the values of the two residues to a type of fault,
- **characterized in that**:

- the first simplified model (M1_j) and said second simplified model (M2j) are each generated from a physical model of the fuel-cell stack incorporating a fuel-cell stack degradation module that takes into account the current and voltage that are applied to said fuel-cell stack in a period prior to said first time,
- said first simplified model (M1_j) is obtained by applying, as input to said physical model of the fuel-cell stack, under nominal operating conditions, a plurality of different current operating points (I_k),
- said second simplified model (M2_j) is obtained by applying, as input to said physical model of the fuel-cell stack, under fault-affected conditions, a plurality of different current operating points (I_k).

11. System according to Claim 10, **characterized in that** the measured electrical impedance and the theoretical impedance correspond to the high-frequency impedance.

**12.** System according to Claim 10 or 11, **characterized in that** it comprises a first module for comparing the obtained first residue with a first threshold value (V1) and a second module for comparing the obtained second residue with a second threshold value (V2).

**13.** System according to one of Claims 10 to 12, **characterized in that** it comprises means for updating off-line each employed simplified model.

**14.** System according to one of Claims 10 to 13, **characterized in that** it comprises:

- means for placing each simplified model (M1_j, M2_j) online at a time Tj,
- a module for computing each simplified module executed during a period extending from a time T_cal_j to Tj,
- a module for acquiring data of measurements of voltage and current of the fuel-cell stack over a period extending from a reference time T0 to the time T_cal_j, said acquired data being injected into said physical model of the fuel-cell stack.

**15.** System according to one of Claims 10 to 14, **characterized in that** it comprises a classifier (CF) configured to generate the second simplified model, said classifier (CF) being configured to classify the obtained residue pairs depending on the type of fault and to generate boundaries delineating a plurality of fault regions.

**16.** System according to Claim 15, **characterized in that** the classifier comprises a k-NN algorithm.

**17.** System according to one of Claims 10 to 16, **characterized in that** it comprises a module for determining a corrective action taking into account the type of fault detected and a module for commanding said determined corrective action.

**18.** Computer program comprising software modules that lead the system according to Claims 10-17 to execute the steps of the method according to Claims 1-9.

**19.** Storage medium readable by a computer comprising the computer program defined in Claim 18.

*Fig. 1*

AME

10a    A    11    C    10b

H2 →

← O2

→ H2O

*Fig. 2*

PAC

U_M_I     U_M_U     U_M_$Z_{HF}$

UC

## *Fig. 3*

Hors ligne

En ligne

STpile_th=D(U_m(0 à T_cal_j), I_m(0 à T_cal_j))

PAC
STpile_r

B1

U_m(T)

I_m(T)

$Z_{HF}$_m(T)

B2

B101

I_k

B103

U_th_1(t)=f(I_k,paramètres nominaux)

B100

MODELE
PHYSIQUE
PILE

MODELE SIMPLIFIE
M1_j
U_th_1=f(I(t))
$Z_{HF}$_th_1(t)=g(I(t))

B3

B102

STpile_th

$Z_{HF}$_th_1(t)=g(I_k,paramètres nominaux)

B104

B4

U_th_1(T)

B5

$Z_{HF}$_th_1(T)

B6

R1(T)

B7

R2(T)

B8

R1>V1

B9

R2>V2

B201

I_k

B203

U_th_1(I_k)

CF

Fi

B10

B206

B200

MODELE
PHYSIQUE
PILE

U_th_2(t)=f(I_k,paramètres, défauts Fi)

B208

R1_th_k

Apprentissage
du classifieur

Utilisation du
classifieur/
MODELE
DEFAUTS **M2_j**
F_r=h(R1(T), R2(T))

$R_{HF}$_th_2(t)=g(I_k,paramètres, défauts Fi)

R2_th_k

B200

STpile_th

Fi

B205

B204

B207

B209

B210

$Z_{HF}$_th_1(I_k)

F_r

B202

B11

*Fig. 4*

*Fig. 5*

STpile_th=D(U_m(0 à T_cal_j), I_m(0 à T_cal_j))
Mj=Modèle généré pour l'instance j
T_cal_j=Instant du début de calcul du modèle Mj
M_I=Mesures du courant
M_U=Mesures de la tension

## RÉFÉRENCES CITÉES DANS LA DESCRIPTION

**Documents brevets cités dans la description**

- WO 2016071801 A1

- FR 2888331 A1

**Littérature non-brevet citée dans la description**

- **C. ROBIN ; M. GERARD ; J. D'ARBIGNY ; P. SCHOTT ; L. JABBOUR ; Y BULTEL.** Development and experimental validation of a PEM fuel cell 2D-model to study heterogeneities effects along large-area cell surface. *International Journal of Hydrogen Energy,* 2015, vol. 40 (32), 10211-10230, https://doi.org/10.1016/j.ijhydene.2015.05.178.